# EUROPEAN PATENT SPECIFICATION

(11) **EP 3 614 501 B1**
(45) Date of publication and mention of the grant of the patent: **22.09.2021**
(21) Application number: 19190502.5
(22) Date of filing: 07.08.2019
(51) Int. Cl.: H01R 13/00, H01R 11/28

(54) **COOLING LANCE AND ELECTRICAL CONTACT ARRANGEMENT WITH A COOLING LANCE**
KÜHLLANZE UND ELEKTRISCHE KONTAKTANORDNUNG MIT EINER KÜHLLANZE
LANCE DE REFROIDISSEMENT ET AGENCEMENT DE CONTACT ÉLECTRIQUE COMPORTANT UNE LANCE DE REFROIDISSEMENT

(30) Priority: 14.08.2018 DE 102018213637
(43) Date of publication of application: 26.02.2020
(73) Proprietor: TE Connectivity Germany GmbH, 64625 Bensheim (DE)
(72) Inventor: Dressel, Andre Martin, 68623 Lampertheim (DE); Toth, Gerzson, 68307 Mannheim (DE); Blumenschein, Rudi, 73479 Ellwangen (DE); Kaehny, Frank, 64686 Lautertal (DE)
(74) Representative: Grünecker Patent- und Rechtsanwälte PartG mbB

(56) References cited:
- DE-A1- 19 921 310
- US-A- 5 780 770
- US-A1- 2015 270 586

## Description

The invention relates to a cooling lance for cooling an electrically conductive contact body, having a lance body which has at least one fluid line for connection to a pump. The invention further relates to an electrical contact arrangement for the connection of electrical conductors, having an electrically conductive contact body which has a recess, and having a cooling lance for cooling the electrically conductive contact body. Furthermore, the invention relates to an application of a cooling lance for cooling an electrically conductive contact body.

Contact arrangements of the above-mentioned type are known in the prior art. Electrically conductive contact bodies for connecting battery modules, which are made up of several mutually interconnected battery cells, or also for connecting a battery disconnect unit to a battery module, are frequently used. In this case, high currents flow through the contact body, which generate resistance heat. Thermal loads can further arise through heat sources, such as occur in, for example, an engine and/or a battery, and among other things can lead to an embrittlement in a contact region of the contact arrangement, with the result that the contact arrangement can break down again. Furthermore, a heated-up contact body can lead to excessive heating-up of the electrical conductor associated therewith.

In the case of a connection to a battery module, in particular the battery cell directly interconnected with the contact body can heat up above a critical operating temperature, with the result that the lifespan and the performance of the contact arrangement can decrease dramatically. Thus, cooling of the contact body is necessary. In vehicles in particular, great demands are placed on the cooling apparatus. Therefore, it should be as low-weight as possible, guarantee optimal transfer of thermal energy and contact the area to be cooled well and constantly over the service life.

US 5,780,770 A concerns a fluid cooled electrical conductor assembly. The assembly includes a terminal having an open end and a fluid passage in communication with the open end. A sleeve is at least partially received within the open end of the terminal. The sleeve has flares end disposed around an electrical conductor and a distal end disposed adjacent to an end of the conductor.

DE 199 21 310 A1 discloses an electric assembly having a cable comprising a plurality of conductors and an isolation, whereby the cable further comprises a central cooling channel extending along the longitudinal axis of the cable.

A traction battery thermal plate assembly is shown in US 2015/0270568 A1. The assembly includes a structure having edge portions defining a cavity and being configured to support a battery cell array. A flexible bladder may be disposed within the cavity between the structure and array.

Against this background, the problem of the invention is that of creating a cooling lance, as well as an electrical contact arrangement with a cooling lance, which guarantees improved and constant cooling performance.

The problem is solved by an inventive cooling lance according to claim 1, in particular by the at least one fluid line opening into a flexible cooling bladder which can be filled with a fluid and inserted into a recess of an electrically conductive contact body.

Furthermore, the abovementioned problem is solved by an electrical contact arrangement according to claim 8, in particular by a flexible cooling bladder, which can be filled with a fluid, being arranged in the recess at least in sections.

Likewise, in order to solve the problem, a cooling lance for cooling an electrical connection is used, the cooling lance having a flexible cooling bladder which can be filled with a fluid and which is arranged in a recess of an electrically conductive contact body at least in sections.

The flexible cooling bladder can adapt to the outline of the recess, which results in a large contact area and good contacting. Since the cooling bladder is situated in a recess, it is protected by the contact body from mechanical loads and can thus be optimised for heat transfer. The contact body can thus be cooled more efficiently from inside. By way of the inventive solution, only a small space is required by the cooling lance, which is highly advantageous above all when used in vehicles. The lance shape enables introduction of the cooling bladder through narrow orifices and/or orifices which are accessible only with difficulty. Hereinafter, further developments are specified which can be combined with one another as desired, independently of one another, and are each themselves advantageous per se. Thus, for example, the cooling bladder can be inflatable, i.e. the cooling bladder is tensioned by the pressure of the fluid gathering in the cooling bladder. As a result, the cooling bladder can have a constant material thickness in the tensioned and relaxed state and thus offers a certain tear resistance.

According to an alternative configuration, it has proven particularly advantageous, however, when the cooling bladder is elastically expandable. Thus, in principle, the cooling bladder can act like a balloon, in which the material thickness of a membrane enclosing a volume space of the cooling bladder decreases when it expands. The decreasing material thickness of the membrane enables a particularly intense temperature exchange between the fluid situated in the volume space and the contact body, owing to the falling heat transmission resistance of the cooling bladder.

The lance body can in particular have at least one elongate tubular body, which can be coolant-resistant and which forms at least one fluid line that can have a fluid flow through it. Preferably, the fluid line can be thermally insulated, so that a coolant flowing through the fluid line is not heated excessively by the warm ambient space, before the coolant is introduced into the cooling bladder. As a result, higher cooling efficiency is possible. Furthermore, the occurrence of condensation can be avoided.

According to an advantageous configuration, the lance body can at least partially be an injection-moulded part. As a result, simple and inexpensive production of the lance body is possible, it being possible to adapt the shape of the lance body to the planned place of use in a simple manner during production. The lance body can be manufactured from an electrically insulating polymer, which has a low weight. Thus, the lance body can be electrically insulating, in order to avoid a disruptive discharge. Furthermore, according to an advantageous configuration, at least the at least one fluid line of the lance body can be mechanically robust, so that the cooling lance can withstand mechanical stress, such as vibrations and impacts for example. As an alternative to this, the lance body can also be manufactured from a metal, for example from copper or a copper alloy, it being possible in this case for the lance body to be wrapped around by an electrically insulating foil or to be electrically insulated from the outside in some other way known to the person skilled in the art.

The lance body can in particular have a fluid inlet and a fluid outlet, which each open into the flexible cooling bladder. The fluid inlet and the fluid outlet can be connected in a coolant circuit, with the result that a continuous, even steady, flow of fluid occurs, once the flexible cooling bladder has been filled. As a result, it is guaranteed that cold fluid is guided continuously through the fluid inlet into the cooling bladder and displaces the fluid already warmed up by the heat exchange with the contact body.

The fluid inlet and fluid outlet can be arranged next to one another at least in sections, with the result that a particularly space-saving configuration arises. In particular, the lance body can extend in a longitudinal direction at least in sections and the fluid inlet and fluid outlet can be arranged next to one another substantially transversely to the longitudinal direction. Therefore, the fluid inlet and the fluid outlet can enter a common orifice of the cooling bladder in the volume space enclosed by the cooling bladder. In this case, the cooling bladder can be attached to a tip of the lance body, which can be introduced into the recess of the contact body. As an alternative to this, the fluid inlet and fluid outlet can in each case open into the volume space of the cooling bladder through a separate orifice. Therefore, the cooling bladder, for example, can be arranged in a portion of the lance body between the fluid inlet and the fluid outlet.

In a particularly advantageous configuration, the fluid inlet and the fluid outlet can be connected to one another, at least in sections, rigidly or even materially, in particular monolithically. Therefore, the fluid inlet and the fluid outlet can be produced in an injection-moulding process, it being possible for the fluid inlet and the fluid outlet each to be formed by a tubular body, and being connected to one another in a way that transfers movement at least in sections. Therefore, fluctuations caused by mechanical loads, such as impact loads or vibration loads, can be attenuated and a relative movement between the fluid inlet and fluid outlet can be prevented. As a result, the cooling bladder connected between the fluid inlet and fluid outlet and/or its connection to the fluid inlet and/or fluid outlet can be prevented from being torn off or damaged in some way.

In order to generate a steady fluid flow, the fluid inlet and the fluid outlet can be connected in parallel. In particular, the amount of fluid which is introduced into the cooling bladder can correspond to the amount of fluid which is led out of the cooling bladder, with the result that the volume space and internal pressure adopted by the cooling bladder remain constant. A constant contacting of the contact body by the cooling bladder and constant cooling over the operating period can thus be guaranteed.

Preferably, the fluid outlet can be connected independently of the fluid inlet. The fluid outlet can be provided with a valve, for example, so that the cooling bladder can first be filled with a fluid and can inflate and/or expand, before the valve for the fluid outlet opens. The valve can be formed in such a way that it enables discharge of the fluid from the cooling bladder only after a predetermined internal pressure in the volume space of the cooling bladder. According to a preferred configuration, a valve can be set in relation to the pressure at which it opens, so that the internal pressure in the volume space, and thus the expansion of the cooling bladder, can be regulated.

The cooling bladder can, in particular, be made up of a material different from the fluid inlet and/or fluid outlet, the cooling bladder guaranteeing as good a heat transfer as possible between the contact body to be cooled and the coolant. Since the cooling bladder at least partially, preferably the entire cooling bladder, can be arranged in a recess of the contact body, the contact body acts like a protective housing which protects the cooling bladder from mechanical loading. Thus, the material of the cooling bladder, possibly at the expense of mechanical durability, can have as high a thermal conductivity as possible.

According to a further advantageous configuration, the cooling bladder can in particular be coolant-resistant, with the result that undesired escape of the coolant from the cooling bladder can be prevented. In this case, the membrane of the cooling bladder can be chemically resistant, preferably inert, as a result of which it can be ensured that the cooling bladder does not become decomposed and leaky during its period of operation.

According to a further advantageous configuration, the membrane can be composed of a material which is stable at least in the temperature range of the field of use. Therefore, in particular the elastic behaviour of the membrane can be stable and not embrittle. Embrittlement of the membrane can lead to tears and can result in an escape of the coolant. Therefore, the elasticity of the membrane can be unchanged at approximately 60°C in comparison with the elasticity of the cooling bladder at approximately -40°C. The flexible cooling bladder can be composed, for example, from a vulcanised rubber or plastic, such as polyethylene for example.

In a further advantageous configuration, the cooling bladder can be connected rigidly, preferably materially, to the at least one fluid line. Therefore, the cooling bladder can have an orifice, the edge of which delimiting the orifice can be fastened to a lateral surface of the at least one fluid line, for example by an adhesive connection. By way of this connection, the fluid is prevented from being able to escape out of the cooling bladder into the environment. The adhering agent can, in this case, be chemically stable, in particular with respect to the coolant, and can be temperature-stable at least in the temperature range from approximately -40°C to approximately 60°C, so that undesired release of the adhesive connection does not occur.

In order to prevent a disruptive discharge between the contact body and the fluid, the cooling bladder can preferably be composed of a material which has dielectric properties. As a result, the cooling bladder acts like an insulator, which electrically insulates the fluid and thus prevents an electrical flow of current from occurring between contact body outside the cooling bladder and the fluid in the interior of the cooling bladder.

According to a further advantageous configuration of the electrical contact arrangement, the recess can have at least one orifice, preferably accessible from outside the contact arrangement, and the cooling lance can be inserted through the orifice. It has proven particularly advantageous when at least the cooling bladder is arranged in the recess, and the at least one fluid line protrudes through the at least one orifice. The number and arrangement of the orifices can be complementary to the number and arrangement of the fluid lines. If the fluid lines are arranged next to one another, they can, however, also be inserted into a common orifice, with the result that a compact construction of the electrical contact arrangement is possible.

The cooling lance can be rigidly connected to the contact body. Therefore, the cooling lance can be connected to the contact body, in particular rigidly, for example by an adhesive connection. As a result, a relative movement between the cooling lance and the contact body can be reduced, and good contacting can be guaranteed over the period of operation.

The cooling lance can occlude the at least one orifice of the recess, so that no contamination, which can damage the cooling bladder arranged in the recess, can enter into the recess. Thus it is possible to further optimise the elastic, thermally conductive and dielectric properties of the cooling bladder at the expense of mechanical resistance. Preferably the cooling lance in the at least one orifice can be firmly adhesively connected to a thermally conductive adhesive, which prevents the cooling bladder from being pulled out of the recess unintentionally. At the same time, a heat exchange between fluid and contact body can also be guaranteed in the region of the at least one orifice.

The recess of the contact body can be formed, for example, as an undercut, but preferably as a chamber and/or cavity. As a result, the cooling bladder can be enclosed in the chamber and/or in the cavity and is thus protected on all sides from mechanical loads, for example impact loads, by the wall of the chamber and/or of the cavity. Furthermore, the cooling bladder can contact as large a surface of the recess as possible and thus increase the cooling performance.

In a particularly advantageous configuration, the cooling bladder can abut against the wall, in particular the internal wall, of the recess when in a state filled with the coolant. Preferably, the cooling bladder can nestle against the wall, with the result that optimal contacting of the contact body is achieved. In this case, the cooling bladder can fill out in particular the cavity and/or the chamber and can push against the wall with a certain internal pressure, in order to promote good contacting. Furthermore, the cooling bladder can expand further, if there is a thermal deformation of the contact body, and can adapt to this deformation, so that the contacting is not worsened over the lifespan of the cooling bladder and/or of the contact body.

The cooling bladder can in particular be arranged tension-free in the recess of the contact body, with the contact area of the cooling bladder expanding and/or inflating when its volume space is filled with a fluid, so that the cooling bladder in the filled state contacts the contact body. Thus, in the emptied state, tears can be prevented from occurring in the surface of the cooling bladder owing to vibrations or similar.

The electrical contact arrangement can be at least one battery cell and the electrically conductive contact body can be connected at least to a battery cell, and as a result the battery cell can likewise be passively cooled by the cooling of the contact body. The electrical contact body can, for example, connect two battery modules together or also can be used to connect a battery disconnect unit (BDU) to a battery module. In this regard, particularly high current flows are conducted, with the result that in particular the first cell of the battery module can be heated above a critical operating temperature, at which the lifespan and performance of the battery decrease. Thus, through the additional cooling of the contact body, the excessive heating-up can be counteracted and safe operation of the battery can be guaranteed.

The electrical contact arrangement can have a housing, which encloses the contact arrangement at least partially, encloses at least the contact body and gives protection from external influences. Therefore, the housing can be, in particular, electrically insulating, so that undesired transfer of current between the contact body and the environment does not occur.

Hereinafter, the invention is described in greater detail by way of example using exemplary embodiments with reference to the attached figures. In the figures, elements which correspond to one another in design and/or function are provided with the same reference symbols.

The combination of features shown and described in the individual exemplary embodiments serves solely the purposes of explanation. According to the statements above, it is possible to dispense with a feature of an exemplary embodiment if its technical effect is of no importance in a particular application. Conversely, according to the above statements, a further feature can be added in an exemplary embodiment if its technical effect is meant to be advantageous or necessary for a particular application.

In the figures:
- Fig. 1: shows a schematic exploded view of an inventive electrical contact arrangement;
- Fig. 2: shows a schematic perspective view of an inventive cooling lance with emptied cooling bladder, depicted in Fig. 1;
- Fig. 3: shows a schematic perspective view of an inventive cooling lance with filled cooling bladder, depicted in Fig. 1; and
- Fig. 4: shows a schematic cross-sectional view of the inventive electrical contact arrangement, depicted in Fig. 1.

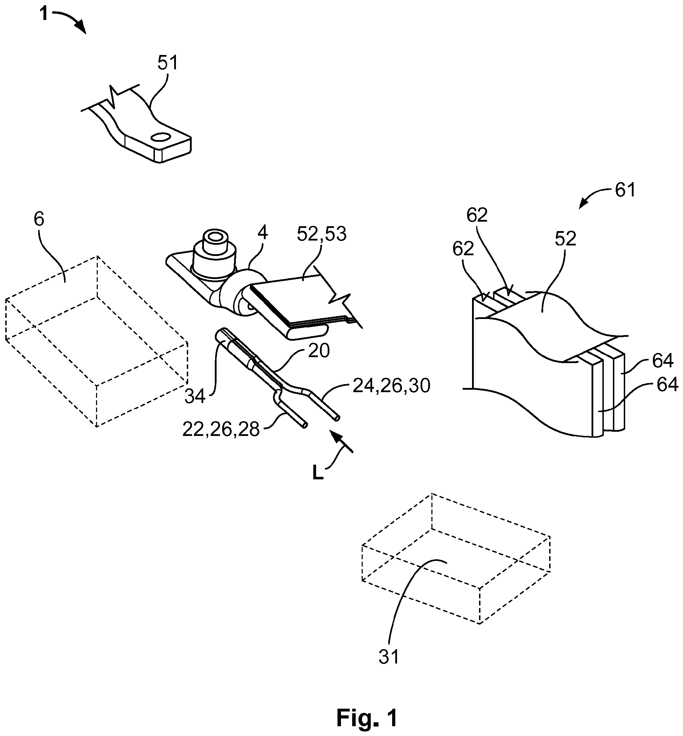

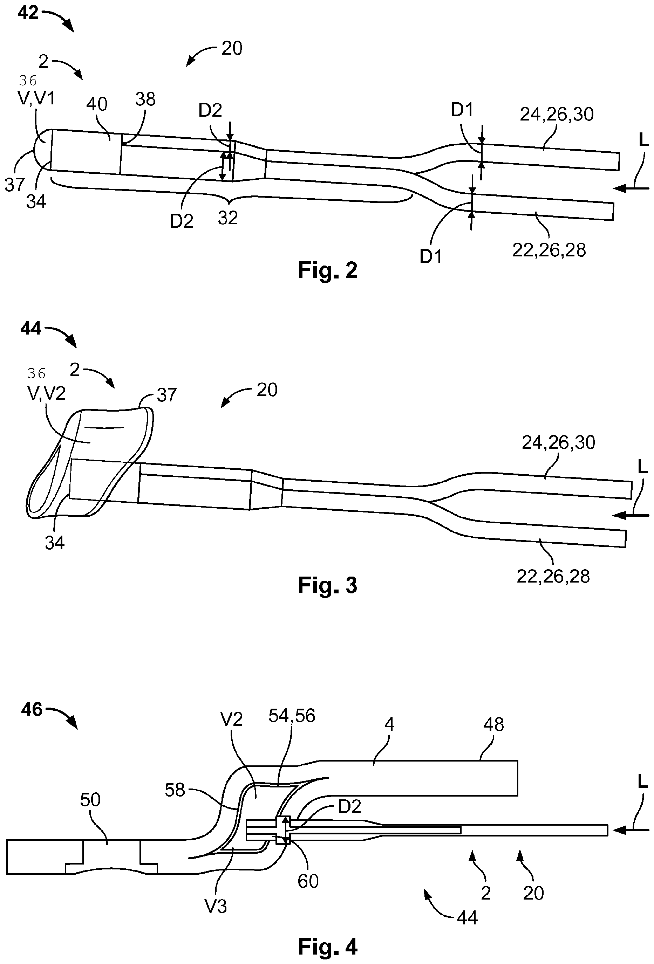

First of all, the construction and the function of an advantageous embodiment of an electrical contact arrangement 1 with a cooling lance 2 and an electrically conductive contact body 4 are described with reference to Figures 1 to 4. In Fig. 2 and Fig. 3, the cooling lance 2 depicted in Fig. 1 is shown in an emptied and a filled state. Finally, a cross-sectional view of an inventive contact arrangement 1 with an electrically conductive contact body 4 and the cooling lance 2 depicted in Figs. 2 and 3 is shown in Fig. 4, in which the cooling lance 2 is inserted in the contact body 4.

The electrical contact arrangement 1 comprises a cooling lance 2 and an electrically conductive contact body 4. At least the electrically conductive contact body 4 is surrounded by an electrically insulating housing 6 (depicted schematically). The housing 6 can furthermore have several supports spaced apart in a longitudinal direction L, on which supports the cooling lance 2 can rest (not shown). The supports can be formed, for example, by wall portions with a depression which are arranged transversely to the longitudinal direction L. The depressions of successive wall portions can align with one another, so that they form a channel into which the cooling lance 2 can be inserted. The supports can prevent large relative movements between contact body 4 and cooling lance 2, which are caused owing to mechanical loads, such as for example by vibrations in a vehicle, with the result that breaking-apart of the contact arrangement 1 can be avoided.

The cooling lance 2 from Fig. 1 is described hereinafter with reference to Figs. 2 and 3, which each show a schematic perspective view of the cooling lance.

The cooling lance 2 has a lance body 20, which is formed from two tubular bodies 22, 24 which are arranged symmetrically in relation to one another at least in sections along the longitudinal direction L, the tubular bodies 22, 24 each forming a fluid line 26. The tubular body 22 functions as a fluid inlet 28 and the tubular body 24 as a fluid outlet 30. The fluid inlet 28 and the fluid outlet 30 can be connected in a coolant circuit (not depicted). The fluid lines 26 can be in fluidic communication with a pump (not shown), with the result that the fluid flow can be controlled and can be pumped through the fluid line 20. The fluid lines 26 can be attached directly to the pump 31, or can be connected in a coolant circuit operated by the pump 31.

The fluid inlet 28 and the fluid outlet 30 run next to one another in an end portion 32 of the lance body 20 parallel and transversely to the longitudinal direction L, and are connected to one another preferably rigidly, even materially in particular as a monolithic structural part, so that at least in the end portion relative movements between the fluid lines 26 are avoided. As a result, high mechanical stability of the lance body 20 is achieved.

Preferably, a cooling liquid such as water is conveyed through the cooling lance 2, which has good thermal conductivity and is chemically inert with respect to the material of the cooling lance 2, so that a chemical decomposition of the cooling lance 2 can be prevented. The decomposition can result, for example, in a loss of insulation of the fluid from the contact body 4 and/or an undesired escape of the coolant.

The lance body 20 is preferably produced by an injection-moulding process, the lance body 20 being composed of a mechanically robust and electrically insulating material, so that transfer of current between the contact body 4 and the fluid situated in the interior of the lance body 20 is prevented. As a result, safe operation without additional insulation of the lance body 20 can be guaranteed. An additional insulation would lead to a higher weight and a larger space requirement.

In the end portion 32, the fluid lines 26 are arranged parallel to one another and their diameter increases from a diameter D1 to a diameter D2 in the longitudinal direction L. Preferably, in this case only the outer diameter increases when the inner diameter remains the same. As a result, the material thickness of the lance body 20 in the end portion 32 can be increased, with the result that a higher mechanical strength is achieved.

The fluid lines 26 open with their free ends 34 into a flexible cooling bladder 36, which encloses a volume space V. The flexible cooling bladder 36 is provided with an orifice 38, which engages around a longitudinal portion of the lance body 20 and is materially connected to said longitudinal portion preferably by an adhesive connection 40. As a result, a fluid can be conducted into the cooling bladder 36, it being ensured that the fluid does not escape in an undesired manner from the cooling bladder 36 into the environment. The adhesive connection 40 is preferably produced from an adhesive which is thermally stable at least in the employed temperature range of approximately -40°C to approximately 60°C, and from at least one adhesive which is chemically stable at least with respect to an employed cooling fluid. The free ends 34 of the fluid lines 34 protrude, in this case, into the volume space V, with the result that the cooling fluid is pumped centrally into the cooling bladder 36, instead of from one side. As a result, homogeneous temperature distribution in the volume space V can be obtained, and consequently homogeneous cooling of the contact body can also be achieved.

As an alternative to this, according to an embodiment not shown, the cooling bladder 36 and the fluid lines 26 can be manufactured in one piece as a monolithic structural part, the cooling bladder 36 being designed to be flexibly expandable and/or inflatable and the fluid lines 26 being substantially mechanically robust. Therefore, the monolithic structural part can be produced inexpensively in only one operation in a multi-component injection-moulding process.

The flexible cooling bladder 36 can preferably be manufactured from an elastic membrane 37, which possesses dielectric properties, and thus prevents a disruptive discharge between contact body 4 and cooling fluid. By way of the elastic properties of the membrane 37, the cooling bladder can be deformed in a reversibly elastic manner. Insulating a recess in the contact body 4 is associated with great outlay and costs. Since the cooling bladder 36 itself, however, can be composed of a membrane 37 with dielectric properties, an undesired flow of current can be prevented and a simple and inexpensive solution for the electrical insulation of the contact arrangement 1, in particularly of the contact body 4, is obtained.

In Fig. 2, the flexible cooling bladder 36 is depicted in an emptied state 42, in which the cooling bladder 36 is substantially tension-free and encloses a volume space V1. In the emptied state 42, the cooling bladder 36 can be spaced apart from a contact area of the contact body 4. In this regard, the emptied state 42 is not limited to a completely emptied cooling bladder, rather this means only that the cooling bladder 36 is not filled with a cooling fluid to the extent that the cooling bladder 36 contacts a contact area of the contact body 4 and a heat exchange between cooling fluid and contact body 4 can take place.

The elastic membrane 37 of the flexible cooling bladder 36 preferably has a small material thickness, and is at least inflatable, but preferably also expandable. By way of the pump, the cooling fluid can be pumped into the cooling bladder 36 via the fluid inlet 28. As a result, the internal pressure in the volume space V rises, which leads to an enlargement to a volume space V2, as depicted in Fig. 3. If no more fluid is conveyed through the fluid inlet 28 into the cooling bladder 36, the membrane can contract again, pump the fluid through the fluid outlet 30 and assume the emptied state 42.

According to a depiction, not shown, the fluid outlet 30 can be provided with a valve (not shown), which opens only at a predetermined internal pressure of the cooling bladder 36, so that the cooling bladder 36 first assumes a predetermined volume space V, before the fluid flows out of the cooling bladder 36 through the fluid outlet 30. As a result, it can be ensured that the cooling bladder 36 is contacted sufficiently well by the contact body 4 with a certain pressing force, which arises as a result of the internal pressure of the cooling bladder 36. The cooling lance 2 depicted in Fig. 3 shows the cooling bladder 36 in a filled state 44. The term "filled state" in this regard merely means that the cooling bladder 36 is filled sufficiently in order to contact a contact area of the contact body 4 with a desired force. The cooling bladder 36 can preferably be filled far beyond the filled state. As a result, it is guaranteed that sufficient volume capacity is present in the cooling bladder 36, before the cooling bladder 36 bursts. The filled state 44 can vary over the period of operation, for example when the contact area is changed by way of thermal deformation of the contact body 4. Therefore, the cooling bladder 36 can adapt to the thermal deformation and, where appropriate, expand further.

The fluid outlet 30 and the fluid inlet 28 can be connected in parallel, preferably after the predetermined internal pressure of the cooling bladder 36 has been reached. The fluid flow can thus flow steadily through the cooling bladder 36, with the result that the internal pressure remains substantially constant, the contact area is contacted lastingly with the same force and a consistent cooling performance which can be designed simply in computational terms is achieved.

As an alternative to this, the fluid inlet 28 and the fluid outlet 30 can be connected in parallel already from the beginning onwards, the current flow being non-steady at the beginning, while the cooling bladder fills up, so that the inlet flow of fluid is higher than the outlet flow, until the cooling bladder 36 reaches the filled state 44. In particular after the cooling bladder has reached the filled state 44, the current flow can be steady, so that the internal pressure prevailing in the volume space V remains constant.

It has proven particularly advantageous when the cooling bladder 36 expands during filling, so that the material thickness of the membrane 37 is smaller in the filled state 44 than in the emptied state 42. By way of this configuration, the thermal transmission resistance of the membrane falls and the thermal conductivity of the cooling lance 2 rises, with the result that a particularly effective cooling of the contact body 4 is achieved. The volume space V2 in the filled state 44 can be a multiple of the volume space V1 in the emptied state 42, depending on the application. Therefore, the expansion ratio between the cooling bladder in the filled state 44 and in the emptied state 42 can be 8:1.

An inventive contact arrangement 1 with an electrically conductive contact body 4 and the cooling lance 2 depicted in Figs. 2 and 3 is shown in Fig. 4.

The contact body 4 has a substantially step-shaped body, in each case a horizontal portion running substantially parallel to the longitudinal direction L forming a contact region 46, 48 for contacting an electrical conductor in each case. The contact body 4 can, for example, be composed of two components, which are connected to one another, for example by diffusion soldering or welding, in each case one component forming a contact region 46, 48. Therefore, the contact region 46, for example, can be formed substantially from copper and the contact region 48 substantially from aluminium. "Substantially" in this case denotes alloys which predominantly contain said material. Thus, this does not preclude these elements from additionally containing further materials.

The contact regions 46, 48 can preferably be formed as stamped and bent parts, with the result that simple production of the contact body 4 is enabled.

The contact region 46 is provided with a fixing orifice 50, which can serve for connection to a first electrical conductor 51, which is depicted schematically in Fig. 1, and also for the mechanical fixing of the contact body 4. The fixing orifice 50 can, for example, be provided with an internal thread for a screw connection. Overall, the contact region 46 can substantially have the shape of a cable lug.

The contact region 48 can likewise have the shape of a cable lug, but can also have no fixing orifice like in the embodiment of the contact region 48 depicted in Fig. 4. In the event of a substantially identical material composition of the contact region 48 and of a second electrical conductor 53, the contact region 48 with the second electrical conductor 53, for example a cell connector 52 (see Fig. 1) of a battery module, can be produced easily by welding or other material connections.

At the transition between the contact regions 46, 48, which runs substantially perpendicular to the longitudinal direction L, the contact body 4 has a recess 54 in the form of a chamber 56, which is enclosed by a wall 58. The chamber 56 describes a volume space V3 and has an orifice 60 accessible in the longitudinal direction L, into which the cooling lance 2 is inserted, so that the cooling bladder 36 is arranged in the chamber 56. As a result, the cooling bladder 36 is protected by the wall 58 against external loads, in particular mechanical loads, such as vibrations or impacts. Thus, the membrane 37 of the cooling bladder 36 can be optimised for thermal transmission at the expense of mechanical robustness.

The lance body 20 is connected rigidly, preferably materially, to the contact body 4 in the orifice 60. For this purpose, an adhesive connection is preferably produced using a thermally conductive adhesive. By way of the rigid connection, the cooling bladder 36 can be prevented from being pulled out of the chamber 56 and/or damaged. Relative movements between the cooling lance 2 and the contact body 4 in the longitudinal direction L, and also transversely to the longitudinal direction L, can also be minimised. In this case, the lance body 20 preferably occludes the orifice 60, and thus prevents the entry of particles which can lead to a lowering of the thermal conductivity and to damage to the membrane 37.

The free end 34 protrudes into the chamber 56, with the result that greater stability of the connection between lance body 20 and orifice 60 is achieved. The connection is thereby not so easily released as a result of vibrations or other mechanical influences.

For cooling the contact body 4, the cooling fluid is pumped into the cooling bladder 36 via the coolant circuit, the cooling bladder 36 inflating and/or expanding up to the volume space V2 in this case. In this case, the cooling bladder 36 substantially assumes the volume space V3 and the outline of the chamber 56. This leads to the membrane 37 nestling against the wall 58, and thus a large contact area arises between cooling bladder 36 and contact body 4. Since the cooling bladder 36 is arranged in the interior of the contact body 4, so to speak, a much larger contact area is contacted in contrast to cooling on a single outer side of the contact body 4. As a result, particularly homogeneous distribution of the cooling is achieved, and the contact area is maximised with a small space requirement. As a result of the internal pressure prevailing in the volume space V2, the membrane 37 is pressed against the wall 58, with the result that continuous contacting of the contact area is guaranteed.

Thus, by way of the inventive cooling lance 2, electrical contact arrangement 1 and use of a cooling lance, for cooling an electrically conductive contact body 4, simple and efficient cooling is possible without the use of further components which could lead to an increase in weight.

In Fig. 1, it is further depicted that the contact body 4 is connected to a cell connector 52 of a battery module 61. The battery module 61 is only shown schematically for the sake of clarity, only two single battery cells 64 of a battery module 61 being shown. The cell connector 52 can, for example, be welded to an end face 62 of the battery cell 64. The battery modules 61 are cooled in a known manner, for example, by plate cooling. As a result of the ever increasing demands on charging capacities and speeds of batteries, excessive heating-up of the battery cells above a critical temperature occurs as a result of the high power consumption or high power output, with the result that the lifespan of the battery is shortened. In particular, the cell connector 52 connected to the contact body 4 is heated excessively by the heat of the contact body 4. By cooling the contact body 4 efficiently by means of the cooling lance 2, excessive heat which is transferred to the cell connector 52 can be prevented from forming, and thus can prevent the battery cell from heating beyond a critical operating temperature. Thus, the temperature of the battery module 61, in particular the battery cell 64 directly connected to the contact body, can be regulated indirectly by the cooling of the contact body, in addition to the plate cooling.

### Reference numerals

- 1: contact arrangement
- 2: cooling lance
- 4: contact body
- 6: housing
- 20: lance body
- 22: tubular body
- 24: tubular body
- 26: fluid line
- 28: fluid inlet
- 30: fluid outlet
- 31: pump
- 32: end portion
- 34: free end
- 36: cooling bladder
- 37: membrane
- 38: orifice of the cooling bladder
- 40: adhesive connection
- 42: emptied state
- 44: filled state
- 46: contact region
- 48: contact region
- 50: fixing orifice
- 51: electrical conductor
- 52: cell connector
- 53: electrical conductor
- 54: recess
- 56: chamber
- 58: wall
- 60: orifice
- 61: battery module
- 62: end face
- 64: battery cell
- L: longitudinal direction
- D: diameter
- V: volume space

## Claims

1. A cooling lance (2) for cooling an electrically conductive contact body (4), having a lance body (20) which has at least one fluid line (26) for connection to a pump (31), which is in fluidic communication, **characterised in that** the fluid line (26) opens into a flexible cooling bladder (36) which can be filled with a fluid and inserted into a recess (54) of an electrically conductive contact body (4).

2. The cooling lance (2) according to Claim 1, **characterised in that** the lance body (20) is an injection-moulded part.

3. The cooling lance (2) according to Claim 1 or 2, **characterised in that** the lance body (20) has a fluid inlet (28) and a fluid outlet (30), which each open into the flexible cooling bladder (36).

4. The cooling lance (2) according to Claim 3, **characterised in that** the fluid inlet (28) and the fluid outlet (30) are arranged next to one another.

5. The cooling lance (2) according to any one of Claims 1 to 4, **characterised in that** the flexible cooling bladder (36) is coolant-resistant.

6. The cooling lance (2) according to any one of Claims 1 to 5, **characterised in that** the flexible cooling bladder (36) is rigidly connected to the lance body (20).

7. The cooling lance (2) according to any one of Claims 1 to 6, **characterised in that** the flexible cooling bladder (36) is composed of a material with dielectric properties.

8. An electrical contact arrangement (1) for the connection of electrical conductors (51, 53), having an electrically conductive contact body (4) which has at least one recess (54), and having a cooling lance (2) according to any one of Claims 1 to 7, **characterised in that** the flexible cooling bladder (36) of the cooling lance (2), which can be filled with a fluid, is arranged in the recess (54) at least in sections.

9. The electrical contact arrangement (1) according to Claim 8, **characterised in that** the recess (54) possesses at least one orifice (60) and the cooling lance (2) is inserted through the orifice (60).

10. The electrical contact arrangement (1) according to Claim 8 or 9, **characterised in that** the cooling lance (2) is rigidly connected to the contact body (4).

11. The electrical contact arrangement (1) according to Claim 9 or 10, **characterised in that** the orifice (60) is occluded by the cooling lance (2).

12. The electrical contact arrangement (1) according to any one of Claims 8 to 11, **characterised in that** the flexible cooling bladder (36), at least in a filled state (44), abuts against at least one wall (58) of the recess (54).

13. The electrical contact arrangement (1) according to any one of Claims 8 to 12, **characterised in that** the flexible cooling bladder (36), at least in an emptied state (42), is arranged tension-free in the recess (54).

14. The electrical contact arrangement (1) according to any one of Claims 8 to 13, **characterised in that** the contact arrangement (1) has at least one battery cell (64) and the contact body (4) is connected to the at least one battery cell (64).

15. Use of a cooling lance (2) according to any one of Claims 1 to 7 for cooling an electrically conductive contact body (4).

## Patentansprüche

1. Kühllanze (2) zum Kühlen eines elektrisch leitenden Kontakt-Körpers (4), die einen Lanzen-Körper (20) hat, der wenigstens eine Fluidleitung (26) zur Verbindung mit einer Pumpe (31) aufweist, die in Fluidverbindung ist, **dadurch gekennzeichnet, dass** sich die Fluidleitung (26) in eine flexible Kühlblase (36) hinein öffnet, die mit einem Fluid gefüllt und in eine Aussparung (54) eines elektrisch leitenden Kontakt-Körpers (4) eingeführt werden kann.

2. Kühllanze (2) nach Anspruch 1 **dadurch gekennzeichnet, dass** der Lanzen-Körper (20) ein Spritzgussteil ist.

3. Kühllanze (2) nach Anspruch 1 oder 2, **dadurch gekennzeichnet, dass** der Lanzen-Körper (20) einen Fluid-Einlass (28) und einen Fluid-Auslass (30) aufweist, die sich jeweils in die flexible Kühlblase (36) hinein öffnen.

4. Kühllanze (2) nach Anspruch 3, **dadurch gekennzeichnet, dass** der Fluid-Einlass (28) und der Fluid-Auslass (30) nebeneinander angeordnet sind.

5. Kühllanze (2) nach einem der Ansprüche 1 bis 4, **dadurch gekennzeichnet, dass** die flexible Kühlblase (36) kühlmittelbeständig ist.

6. Kühllanze (2) nach einem der Ansprüche 1 bis 5, **dadurch gekennzeichnet, dass** die flexible Kühlblase (36) starr mit dem Lanzen-Körper (20) verbunden ist.

7. Kühllanze (2) nach einem der Ansprüche 1 bis 6, **dadurch gekennzeichnet, dass** die flexible Kühlblase (36) aus einem Material mit dielektrischen Eigenschaften besteht.

8. Elektrische Kontaktanordnung (1) für die Verbindung elektrischer Leiter (51, 53), die einen elektrisch leitenden Kontakt-Körper (4), der wenigstens eine Aussparung (54) hat, und eine Kühllanze (2) nach einem der Ansprüche 1 bis 7 aufweist, **dadurch gekennzeichnet, dass** die flexible Kühlblase (36) der Kühllanze (2), die mit einem Fluid gefüllt werden kann, wenigstens in Abschnitten in der Aussparung (54) angeordnet ist.

9. Elektrische Kontaktanordnung (1) nach Anspruch 8, **dadurch gekennzeichnet, dass** die Aussparung (54) wenigstens eine Öffnung (60) besitzt und die Kühllanze (2) über die Öffnung (60) eingeführt wird.

10. Elektrische Kontaktanordnung (1) nach Anspruch 8 oder 9, **dadurch gekennzeichnet, dass** die Kühllanze (2) starr mit dem Kontaktkörper (4) verbunden ist.

11. Elektrische Kontaktanordnung (1) nach Anspruch 9 oder 10, **dadurch gekennzeichnet, dass** die Öffnung (60) durch die Kühllanze (2) verschlossen wird.

12. Elektrische Kontaktanordnung (1) nach einem der Ansprüche 8 bis 11, **dadurch gekennzeichnet, dass** die flexible Kühlblase (36), wenigstens in einem gefüllten Zustand (44), an wenigstens einer Wand (58) der Aussparung (54) anliegt.

13. Elektrische Kontaktanordnung (1) nach einem der Ansprüche 8 bis 12, **dadurch gekennzeichnet, dass** die flexible Kühlblase (36), wenigstens in einem entleerten Zustand (42) spannungsfrei in der Aussparung (54) angeordnet ist.

14. Elektrische Kontaktanordnung (1) nach einem der Ansprüche 8 bis 13, **dadurch gekennzeichnet, dass** die Kontaktanordnung (1) wenigstens eine Batteriezelle (64) aufweist und der Kontakt-Körper (4) mit der wenigstens einen Batteriezelle (64) verbunden ist.

15. Einsatz einer Kühllanze (2) nach einem der Ansprüche 1 bis 7 zum Kühlen eines elektrisch leitenden Kontakt-Körpers (4).

## Revendications

1. Lance de refroidissement (2) destinée au refroidissement d'un corps de contact électriquement conducteur (4), comprenant un corps de lance (20) qui comporte au moins une ligne de fluide (26) pour une connexion à une pompe (31), qui est en communication fluidique, **caractérisée en ce que** la ligne de fluide (26) débouche dans une vessie de refroidissement flexible (36) qui peut être remplie avec un fluide et insérée dans une cavité (54) d'un corps de contact électriquement conducteur (4).

2. Lance de refroidissement (2) selon la revendication 1, **caractérisée en ce que** le corps de lance (20) est une pièce moulée par injection.

3. Lance de refroidissement (2) selon la revendication 1 ou 2, **caractérisée en ce que** le corps de lance (20) est pourvu d'une entrée de fluide (28) et d'une sortie de fluide (30) qui débouchent chacune dans la vessie de refroidissement flexible (36).

4. Lance de refroidissement (2) selon la revendication 3, **caractérisée en ce que** l'entrée de fluide (28) et la sortie de fluide (30) sont disposées l'une près de l'autre.

5. Lance de refroidissement (2) selon l'une quelconque des revendications 1 à 4, **caractérisée en ce que** la vessie de refroidissement flexible (36) est résistante à l'agent de refroidissement.

6. Lance de refroidissement (2) selon l'une quelconque des revendications 1 à 5, **caractérisée en ce que** la vessie de refroidissement flexible (36) est connectée rigidement au corps de lance (20).

7. Lance de refroidissement (2) selon l'une quelconque des revendications 1 à 6, **caractérisée en ce que** la vessie de refroidissement flexible (36) est constituée d'un matériau ayant des propriétés diélectriques.

8. Agencement de contact électrique (1) destiné à la connexion de conducteurs électriques (51, 53), comprenant un corps de contact électriquement conducteur (4) qui comporte au moins une cavité (54), et comprenant une lance de refroidissement (2) selon l'une quelconque des revendications 1 à 7, **caractérisée en ce que** la vessie de refroidissement flexible (36) de la lance de refroidissement (2), qui peut être remplie avec un fluide, est disposée dans la cavité (54) au moins dans certaines parties.

9. Agencement de contact électrique (1) selon la revendication 8, **caractérisé en ce que** la cavité (54) comprend au moins un orifice (60) et la lance de refroidissement (2) est insérée à travers l'orifice (60).

10. Agencement de contact électrique (1) selon la revendication 8 ou 9, **caractérisé en ce que** la lance de refroidissement (2) est connectée rigidement au corps de contact (4).

11. Agencement de contact électrique (1) selon la revendication 9 ou 10, **caractérisé en ce que** l'orifice (60) est bouché par la lance de refroidissement (2).

12. Agencement de contact électrique (1) selon l'une quelconque des revendications 8 à 11, **caractérisé en ce que** la vessie de refroidissement flexible (36), au moins à l'état rempli (44), bute contre au moins une paroi (58) de la cavité (54).

13. Agencement de contact électrique (1) selon l'une quelconque des revendications 8 à 12, **caractérisé en ce que** la vessie de refroidissement flexible (36), au moins à l'état vidé (42), est disposée sans tension dans la cavité (54).

14. Agencement de contact électrique (1) selon l'une quelconque des revendications 8 à 13, **caractérisé en ce que** l'agencement de contact (1) comprend au moins un élément de batterie (64) et le corps de contact (4) est connecté à l'au moins un élément de batterie (64).

15. Utilisation d'une lance de refroidissement (2) selon l'une quelconque des revendications 1 à 7 pour refroidir un corps de contact électriquement conducteur (4).
